# EUROPÄISCHE PATENTANMELDUNG

(11) **EP 4 310 529 A1**
(43) Veröffentlichungstag der Anmeldung: **24.01.2024**
(21) Anmeldenummer: 23184898.7
(22) Anmeldetag: 12.07.2023
(51) Int. Cl.: G01R 33/38, G01R 33/387, H01F 6/04

(54) **AKTIVE REDUZIERUNG EINES TEMPERATURINDIZIERTEN SHIMDRIFTS BEI NMR-MAGNETSYSTEMEN**

(30) Priorität: 21.07.2022 DE 102022207489
(71) Anmelder: Bruker Switzerland AG, 8117 Fällanden (CH)
(72) Erfinder: Schauwecker, Robert, 8004 Zürich (CH); Bovier, Pierre-Alain, 8050 Zürich (CH); Zaffalon, Michele, 8038 Zürich (CH); Freytag, Nicolas, 8122 Binz (CH); Meister, Roger, 8132 Hinteregg (CH)
(74) Vertreter: Kohler Schmid Möbus Patentanwälte

(57) **Zusammenfassung**

Eine NMR-Apparatur mit einem Magnetspulensystem zur Erzeugung eines homogenen Magnetfelds, welches einen supraleitenden Magneten (1) umfasst, der im Kaltbereich eines Kryostaten innerhalb eines Vakuumbehälters (8) angeordnet ist, und welches ein Shimsystem (7) umfasst, das außerhalb des Vakuumbehälters angeordnete Shimelemente (6) enthält, wobei der supraleitende Magnet über eine Magnetaufhängung (3) eine erste mechanische Verbindungsstelle (11) mit dem Vakuumbehälter aufweist, und wobei das Shimsystem über ein Positionierungselement (5) mit dem Vakuumbehälter eine zweite mechanische Verbindungsstelle (10; 12) aufweist, ist dadurch gekennzeichnet, dass auf mindestens einem Abschnitt eines Pfades entlang dem Vakuumbehälter von der ersten Verbindungsstelle zur zweiten Verbindungsstelle und/oder auf mindestens einem Abschnitt eines Pfades entlang des Positionierungselementes von der zweiten Verbindungsstelle zum Shimsystem ein Regulierungselement (13) zur Regulierung thermisch bedingter Längenänderungen auf dem betreffenden Pfad angeordnet ist. Damit kann die Magnetfeldhomogenität auch bei sich verändernden Temperaturverhältnissen innerhalb und im Umfeld der Apparatur weitestgehend stabil und konstant gehalten werden.

## Beschreibung

Die Erfindung betrifft eine NMR-Apparatur mit einem Magnetspulensystem zur Erzeugung eines homogenen Magnetfelds, welches einen supraleitenden Magneten umfasst, der im Kaltbereich eines Kryostaten innerhalb eines Vakuumbehälters angeordnet ist, und welches ein Shimsystem umfasst, das außerhalb des Vakuumbehälters angeordnete Shimelemente enthält, wobei der supraleitende Magnet über eine Magnetaufhängung eine erste mechanische Verbindungsstelle mit dem Vakuumbehälter aufweist, und wobei das Shimsystem über ein Positionierungselement mit dem Vakuumbehälter eine zweite mechanische Verbindungsstelle aufweist.

Eine solche NMR-Apparatur ist aus der Druckschrift DE 101 04 365 C1 (=Referenz [1]) bekannt geworden.

### Hintergrund der Erfindung

Die vorliegende Erfindung befasst sich ganz allgemein mit dem Bereich der Kernspinresonanz (nuclear magnetic resonance = "NMR"), insbesondere mit gekühlten, in der Regel im Betrieb supraleitenden NMR-Magnetsystemen, bei denen die Homogenität des NMR-Magnetfelds durch ein Shimsystem noch weiter verbessert wird.

Die NMR-Spektroskopie ist ein in der instrumentellen Analytik weitverbreitetes und leistungsfähiges Verfahren, mit dessen Hilfe bei einer zu untersuchenden Substanz, wie beispielsweise einem Kohlenwasserstoff oder einer bioanorganischen Komplexverbindung, die elektronische Umgebung einzelner Atome und die Wechselwirkung der einzelnen Atome mit den benachbarten Atomen untersucht werden kann. Auf diese Weise können zum Beispiel die Zusammensetzung, Struktur und Dynamik der zu untersuchenden Substanz aufgeklärt und ebenfalls die Konzentration der zu untersuchenden Substanz bestimmt werden.

Bei der NMR-Messung wird die Substanz einem starken statischen, homogenen Magnetfeld B₀ ausgesetzt, wodurch die Kernspins in der Substanz ausgerichtet werden. In die zu untersuchende Substanz werden dann hochfrequente elektromagnetische Impulse eingestrahlt. Die hierbei erzeugten, ebenfalls hochfrequenten elektromagnetischen Felder werden im NMR-Spektrometer detektiert. Daraus können dann Informationen über die Eigenschaften der untersuchten Substanz gewonnen werden.

Sowohl bei der hochauflösenden Magnetresonanz Spektroskopie wie auch in der bildgebenden Magnetresonanz sind die Anforderungen an die Magnetfeldhomogenität sehr hoch. Um die Homogenitätsspezifikationen zu erreichen, werden häufig elektrische Kryoshims eingesetzt. Deren Spulen erzeugen elementare Feldprofile. Mit geeigneten Strömen versehen können sie die Homogenität des NMR-Magneten am Probenort verbessern.

Manchmal wird auch kaltes ferromagnetisches Material (beispielsweise Eisen- oder Stahllegierungen) als Shimelement zur Verbesserung der Homogenität verwendet, wie beispielsweise in der Druckschrift DE 10 2015 225 731 B3 (=Referenz [7]) beschrieben wird. Unabhängig davon, wie ein Magnet kalt geshimmt wird, bleibt am Schluss eine Restinhomogenität bestehen, die mittels eines weiteren Shimsystems korrigiert werden muss, welches außerhalb des Vakuumbehälters, typischerweise in der Magnetbohrung, angeordnete Shimelemente umfasst (in der Folge Raumtemperaturshims oder "RT-Shims" genannt). Diese RT-Shims können wie die Kryoshims entweder Shimspulen, die durch RT-Shimströme bestromt werden, oder ferromagnetisches Material oder eine Kombination der beiden umfassen. Obwohl der Name "Raumtemperaturshims" suggeriert, dass sich diese Shims auf Umgebungstemperatur befinden, ist das nicht zwingend der Fall: Die in den Shimspulen dissipierte Leistung sorgt oft dafür, dass ihre Temperatur gegenüber der Umgebungstemperatur leicht erhöht ist. Zudem werden manchmal auch NMR-Experimente mit Probensubstanzen bei variablen Temperaturen durchgeführt.

Der supraleitende Magnet ist mechanisch über einen langen Weg mit den RT-Shims verbunden. Ein erster Teil dieses Weges verläuft im Kaltbereich des Kryostaten und ist durch den Kryostaten temperaturstabilisiert. Ein zweiter Teil ist der Umgebungstemperatur und ihren Schwankungen ausgesetzt. Ein dritter Teil ist sowohl Schwankungen der Umgebungstemperatur als auch Temperaturschwankungen auf Grund des Betriebs der Anordnung ausgesetzt. Der zweite und dritte Teil des Weges verändern ihre Länge aufgrund ihrer thermischen Ausdehnung bei Veränderung der Temperatur. Es kommt folglich zu einer relativen Bewegung zwischen dem supraleitenden Magneten und den RT-Shims. Die Ströme in den RT-Shims und/oder die RT-Ferroshims sind dann nicht mehr ideal zur Kompensation der Feldinhomogenität abgestimmt und die Qualität der Magnetresonanzbilder oder -spektren verschlechtert sich.

Umfassen die RT-Shims Spulen oder Spulensysteme, dann können deren Ströme angepasst und so die ursprüngliche Feldhomogenität wiederhergestellt werden. In diesem Fall manifestiert sich die Verschlechterung der Feldhomogenität durch temperaturinduzierte Relativbewegungen zwischen supraleitendem Magneten und RT-Shims daher als eine "Drift" der benötigten RT-Shimströme.

Empfindliche Geräte werden zwar oftmals in klimatisierten Räumen betrieben, aber Temperaturschwankungen von 1° C während des Tages sind trotzdem keine Seltenheit. In vielen Anwendungen können die RT-Shimströme automatisch angepasst werden. Ist das nicht möglich, können die Homogenitätsschwankungen während der Messung störend sein.

Vergleichbare Homogenitätsschwankungen treten auf, wenn die Temperatur, z.B. in der Magnetbohrung, aus anderen Gründen zeitlich veränderlich ist. Eine solche Situation kommt z.B. vor, wenn die NMR-Messprobe gewechselt wird und neu geshimmt werden muss. Die von den RT-Shims dissipierte Leistung kann sich von der vorherigen RT-Shimleistung unterscheiden und neue Temperaturverhältnisse in der Magnetbohrung hervorrufen. Es braucht dann eine gewisse Zeit, bis sich die Temperatur auf das neue Niveau einpendelt. In dieser Zeit müssen die Shimströme immer wieder angepasst werden. Ein ähnliches Problem tritt auf, wenn die Temperatur der NMR-Messprobe geändert wird.

Weiterhin beeinflussen Schwankungen der Umgebungstemperatur die Temperatur von Druckgas, welches eine Turbine mit der NMR-Messprobe antreibt. Nicht zu vergessen ist zudem die Dissipation im Betrieb von NMR/MRI-Probenköpfen oder von Gradientenspulen.

Eine naheliegende Lösung des Problems kann in erster Näherung darin bestehen, die Fluktuationen der Umgebungstemperatur möglichst klein zu halten. Je größer das Labor, umso teurer und aufwändiger wird es, eine Klimaanlage mit hinreichender Präzision zu betreiben.

In einem zweiten, verfeinerten Ansatz können die Shimströme automatisch der schwankenden Homogenität angepasst werden. Dies ist allerdings nur dann möglich, wenn eine Lock-Substanz verfügbar ist, was z.B. bei Festkörper-NMR-Experimenten nicht der Fall ist.

### Spezieller Stand der Technik:

Ein hochauflösendes NMR-Spektrometer mit einem supraleitenden NMR-Magnetspulensystem, das mit einem Pulsrohrkühler auf kryogene Temperaturen gekühlt wird, und das im Kaltbereich eines Kryostaten innerhalb eines Vakuumbehälters angeordnet ist, wird beschrieben in EP 0 780 698 B1 (= Referenz [2]).

In EP 2 015 092 A1 (= Referenz [3]) wird das Problem der Shimdrift aufgrund von atmosphärischen Druckschwankungen angesprochen. Ähnlich wie bei Temperaturschwankungen kommt es zu einer Relativbewegung zwischen den RT-Shims und dem supraleitenden Magneten. Um die Relativbewegung zu minimieren, wird eine Brücke verwendet, die am äußeren Rand des Kryostaten fixiert wird und somit die Bewegung des zentralen Bereichs des Kryostaten bei Druckschwankungen nicht mitmacht. Das RT-Shimsystem wird an dieser Brücke festgemacht.

Quantitative klinische NMR-Analysegeräte mit einer automatischen Kompensation der Temperatur-Empfindlichkeit über einen großen Temperaturbereich sind in der EP 3 686 620 A1 (= Referenz [4]) beschrieben.

In der Publikation "Acyclic Acids-Advances in Research and Application: 2013 Edition: ScholarlyBrief", Q. Ashton Acton, PhD, ScholarlyEditions, 2013, p139 (= Referenz [5]) wird ebenfalls auf die Temperaturempfindlichkeit der Elektronik in NMR-Analysatoren eingegangen. Eine Temperierung der Elektronik kann demnach Abhilfe schaffen.

Die Publikation "Modern Instrumental Analysis", Satinder Ahuja, Neil Jespersen, Elsevier, 2006, p270 (= Referenz [6]) weist auf die Temperaturempfindlichkeit der Probensubstanz hin. Durch eine Temperaturregulierung am Ort der Substanz kann diesem Effekt entgegengewirkt werden.

Aus der bereits oben zitierten DE 10 2015 225 731 B3 (= Referenz [7]) ist ein Helium-gekühltes supraleitendes Magnetspulensystem in einer NMR-Apparatur mit leicht zugänglicher, ebenfalls tiefgekühlter NMR Shim-Anordnung bekannt. Die NMR-Apparatur weist zwischen einem Heliumbehälterinnenrohr und einem Strahlungsschildinnenrohr eine Feldformeinrichtung auf, welche in starrem mechanischen Kontakt mit dem Heliumbehälter steht, ohne dabei das Strahlungsschildinnenrohr zu berühren.

Die ebenfalls bereits oben zitierte Referenz [1] offenbart eine bezüglich der vorliegenden Erfindung generische NMR-Apparatur mit sämtlichen eingangs definierten Merkmalskomplexen einschließlich dem gattungsgemäßen Shimsystem. Allerdings bestehen auch bei dieser Apparatur die oben beschriebenen Probleme hinsichtlich von Schwankungen der MagnetfeldHomogenität aufgrund von Temperaturveränderungen in einem auch in Laboren üblichen Rahmen.

### Aufgabe der Erfindung

Der vorliegenden Erfindung liegt demgegenüber die Aufgabe zugrunde, eine NMR-Apparatur mit den eingangs definierten Merkmalen mit Hilfe besonders einfacher, leicht zugänglicher technischer Mittel sowie möglichst kostengünstig so zu modifizieren, dass die Magnetfeldhomogenität auch bei sich verändernden Temperaturverhältnissen innerhalb und im Umfeld der Apparatur weitestgehend stabil und konstant gehalten wird.

### Kurze Beschreibung der Erfindung

Diese Aufgabe wird durch die vorliegende Erfindung auf ebenso überraschend einfache wie wirkungsvolle Weise dadurch gelöst, dass auf einem Abschnitt eines Pfades entlang des Vakuumbehälters von der ersten mechanischen Verbindungsstelle zur zweiten mechanischen Verbindungsstelle und/oder auf einem Abschnitt eines Pfades entlang des Positionierungselementes von der zweiten mechanischen Verbindungsstelle zum Shimsystem ein Regulierungselement zur Einstellung der Dehnung des Vakuumbehälters und/oder des Positionierungselementes entlang des Pfadabschnittes angeordnet ist.

Durch den Einsatz des erfindungsgemäß vorgesehenen Regulierungselementes wird die Dehnungsänderung in einem Abschnitt eines Pfades entlang des Vakuumbehälters und/oder entlang des Positionierungselementes des Shimsystems bei variabler Umgebungs- oder Systemtemperatur minimiert, so dass die Relativbewegung zwischen supraleitendem Magneten und Shimsystem klein gehalten wird. Dadurch bleibt die Feldhomogenität stabil.

Regulierungselemente können als mechanische Aktuatoren oder als Heiz- oder Kühlelemente ausgeführt und an verschiedenen Orten auf dem Pfad angebracht sein.

Als mechanische Aktuatoren können beispielsweise Piezoelemente verwendet werden. Als Heizelemente können elektrische Widerstandsheizer verwendet werden. Als Kühlelemente können thermoelektrische Kühler (TEC) verwendet werden.

Die Bereiche mit Heiz- bzw. Kühlelementen werden künstlich wärmer bzw. kälter gehalten als die Umgebungstemperatur. Damit nicht zu viel Heiz- bzw. Kühlleistung verloren geht, empfiehlt es sich, die entsprechenden Bereiche von der Umgebung thermisch zu isolieren.

Möglich ist auch, die Temperatur in einem Abschnitt eines Pfades entlang des Vakuumbehälters und/oder entlang des Positionierungselementes des Shimsystems mittels temperierter Gase konstant zu halten. Diese Lösung kommt vorzugsweise zur Temperaturstabilisierung innerhalb der Magnetbohrung zum Einsatz.

Weiterhin kann die Temperatur in einem Abschnitt eines Pfades entlang des Vakuumbehälters und/oder entlang des Positionierungselementes des Shimsystems durch Wärmeleitungselemente, z.B. basierend auf Heatpipes in Kombination mit Heizern und/oder TEC's stabilisiert werden. Wärmeleitungselemente reduzieren Temperaturgradienten auf dem Pfad und reduzieren daher die benötigte Anzahl an Regulierungselementen.

Wird zusätzlich zu den Regulierungselementen ein Sensorelement zur Messung der Dehnung und/oder der Temperatur des Vakuumbehälters und/oder des Positionierungselementes benutzt, dann kann mit Hilfe einer elektronischen Regelungseinheit ein Regelkreis zur Stabilisierung der Dehnung und/oder der Temperatur des Vakuumbehälters und/oder des Positionierungselementes betrieben werden, wodurch das Ziel einer zeitlich stabilen Feldhomogenität bei variabler Umgebungs- oder Systemtemperatur am besten erreicht wird.

### Bevorzugte Ausführungsformen und Weiterbildungen der Erfindung

Bei einer ganz besonders bevorzugten Klasse von Ausführungsformen der erfindungsgemäßen NMR-Apparatur umfasst das Regulierungselement ein Temperierelement und/oder einen Wärmetauscher zur Übertragung von Wärme an ein oder aus einem temperierten Fluid.

Temperaturänderungen führen zu Dehnungsänderungen eines Vakuumbehälters und/oder eines Positionierungselementes. Mit einer Regulierung der Temperatur dieser Komponenten kann den temperaturinduzierten Dehnungsänderungen ursächlich entgegengewirkt werden. Dadurch wird die Relativbewegung zwischen dem supraleitenden Magneten und dem Shimsystem minimiert und die Feldhomogenität bleibt stabil.

Bei denjenigen Ausführungsformen, bei welchen das Regulierungselement einen Wärmetauscher umfasst, strömt auf einem Abschnitt des Pfades entlang des Vakuumbehälters von der ersten mechanischen Verbindungsstelle zur zweiten mechanischen Verbindungsstelle und/oder auf einem Abschnitt des Pfades entlang des Positionierungselementes von der zweiten mechanischen Verbindungsstelle zum Shimsystem ein temperiertes Fluid.

Diese Ausführungsform ist besonders geeignet für eine ungeregelte Temperaturstabilisierung der betroffenen Komponenten. Es ist also keine Überwachung der Temperatur der Komponenten nötig. Das Fluid kann ein Gas oder eine Flüssigkeit sein.

Bei bevorzugten Weiterbildungen dieser Klasse von Ausführungsformen ist das Temperierelement als ein Heizelement ausgeführt, vorzugsweise als ein elektrischer Widerstandsheizer, und/oder das Temperierelement ist als Kühlelement, insbesondere als ein thermoelektrischer Kühler ausgeführt.

Gegenüber einer Temperaturregulierung mittels eines temperierten Fluids stellen Heiz- oder Kühlelemente eine apparative Vereinfachung dar.

Thermoelektrische Kühler, auch Peltier-Elemente genannt, sind elektrothermische Wandler, die basierend auf dem Peltier-Effekt bei Stromdurchfluss eine Temperaturdifferenz erzeugen. Sie können sowohl zum Kühlen wie auch zum Heizen verwendet werden. Mit geeigneter Wahl des Stromes kann die Heiz- oder Kühlleistung so eingestellt werden, dass die Temperatur stabil bleibt.

Vorteilhaft sind auch Ausführungsformen der Erfindung, bei welchen das Regulierungselement mindestens einen, vorzugsweise mechanischen, Aktuator umfasst, insbesondere einen Motor und/oder ein Piezoelement, mittels dessen die Dehnung des Vakuumbehälters und/oder des Positionierungselementes entlang des Pfadabschnittes und/oder die Lage des Positionierungselementes gegenüber dem Vakuumbehälter eingestellt werden kann.

Wenn temperaturinduzierte Dehnungsänderungen mechanisch kompensiert werden, dann kann auf eine Temperaturregulierung der betroffenen Komponenten verzichtet werden. Mechanische Regulierungselemente können gegenüber thermischen Regulierungselementen eine apparative Vereinfachung darstellen, und sie können die Dehnung oder Positionierung der betroffenen Komponenten präziser und mit geringerer zeitlicher Verzögerung regulieren.

Insbesondere kann bei diesen Ausführungsformen vorgesehen sein, dass das Regulierungselement mindestens ein Piezoelement umfasst, mittels dessen eine Positions- oder Dehnungsänderung eines Pfadabschnitts korrigiert werden kann.

Das Piezoelement kann zum Beispiel im Positionierungselement eingebaut sein. Durch Anlegen einer elektrischen Spannung kann seine Länge so angepasst werden, dass die Gesamtlänge des Positionierungselementes zeitlich konstant bleibt.

Besonders bevorzugt ist eine Klasse von Ausführungsformen der Erfindung, welche sich dadurch auszeichnet, dass auf einem Abschnitt eines Pfades entlang des Vakuumbehälters von der ersten mechanischen Verbindungsstelle zur zweiten mechanischen Verbindungsstelle und/oder auf einem Abschnitt eines Pfades entlang des Positionierungselementes von der zweiten mechanischen Verbindungsstelle zum Shimsystem ein Sensorelement zur Messung der Dehnung und/oder der Temperatur des Vakuumbehälters und/oder des Positionierungselementes entlang des Pfadabschnittes angeordnet ist, welches vorzugsweise ein Thermometer, insbesondere einen PT-100 Sensor, und/oder ein Dehnungsmesselement umfasst.

Mit dem Sensorelement kann ein Regulierungselement nicht nur gesteuert, sondern auch geregelt betrieben werden. Insbesondere werden mechanische Aktuatoren zur Kompensation einer temperaturinduzierten Dehnungsänderung einer Komponente vorzugsweise durch einen mechanischen Sensor geregelt. Thermische Regulierungselemente werden vorzugsweise durch eine Messung der zu stabilisierenden Komponententemperatur geregelt. In beiden Fällen kann die Relativbewegung zwischen dem supraleitenden Magneten und dem Shimsystem klein gehalten werden. Dadurch bleibt die Feldhomogenität stabil.

Als thermisches Sensorelement sind Platin-Widerstandsthermometer (typischerweise PT-100) besonders geeignet, weil sie im Bereich der Raumtemperatur genaue Temperaturmessungen ermöglichen.

Wenn das Sensorelement ein Dehnungsmesselement umfasst, dann sind insbesondere vorteilhaft ein Widerstandssensor, vorzugsweise ein Dehnungsmessstreifen, oder ein optischer Dehnungssensor, vorzugsweise ein Faser-Bragg-Gitter-Sensor, oder ein Laser, mit welchem mittels einer elektrooptischen Distanzmessung, insbesondere interferometrisch, eine Dehnungsänderung eines beobachteten Pfadabschnitts detektiert werden kann.

Ein Dehnungsmesselement kann zum Beispiel die Längenänderung des Positionierungselementes oder eines Aufhängeturms messen und als Steuergröße an einen Regelkreis zur Stabilisierung der Dehnung dieser Komponente leiten.

Bei weiteren bevorzugten Weiterbildungen dieser Klasse von Ausführungsformen ist das Regulierungselement an einem Ort auf einem Abschnitt eines Pfades entlang des Vakuumbehälters von der ersten mechanischen Verbindungsstelle zur zweiten mechanischen Verbindungsstelle und/oder auf einem Ort auf einem Abschnitt eines Pfades entlang des Positionierungselementes von der zweiten mechanischen Verbindungsstelle zum Shimsystem angeordnet, und das Sensorelement ist an einem anderen Ort desselben oder eines anderen Pfadabschnitts angeordnet.

Wenn die an einer Komponente gemessene Temperatur- oder Dehnungsänderung nicht an derselben Komponente kompensiert werden muss, können Regulierungselemente eingespart werden. Beispielsweise kann ein einziger mechanischer Aktuator am Positionierungselement angebracht werden, welcher die kumulierte gemessene Dehnungsänderung des Aufhängeturms und des Positionierungselementes ausgleicht.

Bei weiteren vorteilhaften Ausführungsformen der Erfindung ist auf einem Abschnitt eines Pfades entlang des Vakuumbehälters von der ersten mechanischen Verbindungsstelle zur zweiten mechanischen Verbindungsstelle und/oder auf einem Abschnitt eines Pfades entlang des Positionierungselementes von der zweiten mechanischen Verbindungsstelle zum Shimsystem eine thermische Isolation angebracht, welche das Regulierungselement thermisch von der Umgebung abkoppelt.

Eine thermische Isolation ist eine passive Massnahme zur Stabilisierung der Temperatur des Positionierungselementes oder einer Komponente des Vakuumbehälters, insbesondere der Aufhängetürme. Dies unterstützt die aktiven Stabilisierungsmassnahmen gemäß der vorliegenden Erfindung und erhöht deren Effizienz.

Ebenfalls bevorzugt sind Ausführungsformen der Erfindung, bei denen der Vakuumbehälter eine vertikale Raumtemperatur-Bohrung aufweist, in welcher das Shimsystem angeordnet ist, und bei denen das Positionierungselement einen Klemmring umfasst, wobei die Auflagefläche des Klemmrings auf dem oberen Ende der Raumtemperatur-Bohrung des Vakuumbehälters die zweite mechanische Verbindungsstelle bildet.

Bei vertikaler Ausrichtung der Raumtemperatur-Bohrung führen Temperaturänderungen zu einer vertikalen Verschiebung des Shimsystems relativ zum Magnetspulensystem. Die Auswirkung einer temperaturinduzierten Dehnung des Vakuumbehälters auf die Feldhomogenität ist also proportional zum vertikalen Abstand zwischen erster und zweiter mechanischer Verbindungsstelle. Wenn das Positionierungselement mit einem Klemmring am oberen Ende der Raumtemperatur-Bohrung angebracht wird, dann reduziert sich dieser vertikale Abstand näherungsweise auf die Höhe der Aufhängetürme, welche typischerweise nur einen Bruchteil der Gesamthöhe des Vakuumbehälters ausmacht.

Besonders vorteilhaft sind auch Ausführungsformen der Erfindung, bei denen auf dem Pfad entlang des Vakuumbehälters von der ersten mechanischen Verbindungsstelle zur zweiten mechanischen Verbindungsstelle und/oder auf dem Pfad entlang des Positionierungselementes von der zweiten mechanischen Verbindungsstelle zum Shimsystem abschnittsweise Materialien mit unterschiedlichen Wärmeausdehnungskoeffizienten eingesetzt sind, deren Wärmeausdehnungen sich jeweils gegenseitig kompensieren.

Damit bleiben dann nur noch deutlich geringere absolute Wärmeausdehnungen übrig, die im Rahmen einer Feinjustage mit Hilfe der Erfindung schließlich auch noch minimiert werden können.

Bei besonders bevorzugten Ausführungsform der erfindungsgemäßen NMR-Apparatur sind auf mindestens einem Abschnitt eines Pfades entlang des Vakuumbehälters von der ersten mechanischen Verbindungsstelle zur zweiten mechanischen Verbindungsstelle und/oder auf mindestens einem Abschnitt eines Pfades entlang des Positionierungselementes von der zweiten mechanischen Verbindungsstelle zum Shimsystem nur Materialien eingesetzt, deren Wärmeausdehnungskoeffizient bei Betriebstemperatur kleiner ist als 5 ppm/K.

Übliche Metalle haben Wärmeausdehnungskoeffizienten in der Gegend von 20 ppm/K. Wird ein Material mit wesentlich kleinerem Wärmeausdehnungskoeffizienten verwendet, wirken sich Temperaturschwankungen weniger auf die Relativbewegung zwischen supraleitendem Magneten und Shimsystem aus.

Ein Metall mit einem Wärmeausdehnungskoeffizienten von ca. 2 ppm/K ist z.B. Invar. Invar eignet sich als Material für den Vakuumbehälter, weil es vakuumdicht schweißbar ist. Dabei ist zu bedenken, dass Invar durch das Hintergrundfeld des supraleitenden Magneten magnetisiert wird. Da sich Invar nur im kleinen Streufeldbereich des supraleitenden Magneten befindet, sind zumindest bei aktiv abgeschirmten Magneten keine Nachteile zu erwarten. Die Kräfte und das Störfeld der Magnetisierung sind jedenfalls klein.

Bei den Nichtmetallen zeichnet sich z.B. Carbon verstärkter Kunststoff (CFK) mit einem Wärmeausdehnungskoeffizienten von weniger als 1 ppm/K in Faserrichtung aus. Dieses Material eignet sich insbesondere für das Positionierungselement. Weil die thermische Ausdehnung von CFK oder von ähnlichen Materialien kleiner ist als die thermische Ausdehnung aller Metalle, inklusive Invar, ist es zielführend, solche Materialien auf einem möglichst großen Anteil der Verbindungslänge zwischen Shimsystem und der ersten mechanischen Verbindungsstelle zu verwenden. Zu diesem Zweck kann das Positionierungselement mit einem Gerüst aus CFK bis zu den Aufhängetürmen verlängert und an diesen fixiert werden. In einer solchen Anordnung fallen erste und zweite mechanische Verbindungsstelle näherungsweise zusammen, wodurch temperaturinduzierte Dehnungsänderungen des Vakuumbehälters fast keine Verschiebung des Shimsystems gegenüber dem supraleitenden Magneten hervorrufen und für die Stabilität der Feldhomogenität unbedeutend werden.

Bei einer weiteren, besonders bevorzugten Klasse von Ausführungsformen der erfindungsgemäßen NMR-Apparatur ist der supraleitende Magnet in einem im Betrieb mit flüssigem Helium gefüllten Heliumbehälter des Kryostaten innerhalb des Vakuumbehälters angeordnet, wobei der Heliumbehälter vorzugsweise von einem mit flüssigem Stickstoff gefüllten Stickstoffbehälter des Kryostaten radial umgeben ist.

Um die Wärmeleitung in den Heliumbehälter zu minimieren, wird dieser nicht direkt am Mantel oder Deckel des Vakuumbehälters, sondern über eine Magnetaufhängung mittels der ersten mechanischen Verbindungsstelle an einer turmartigen Verlängerung des Vakuumbehälters (Aufhängeturm) befestigt. Durch diese nützliche Verlängerung des Wegs von der ersten mechanischen Verbindungsstelle zum Heliumbehälter verlängert sich aber auch der Pfad entlang des Vakuumbehälters von der ersten zur zweiten mechanischen Verbindungsstelle. Folglich führen temperaturinduzierte Dehnungsänderungen des Vakuumbehälters in solchen Systemen zu besonders großen Verschiebungen des Shimsystems gegenüber dem supraleitenden Magneten und zu besonders großen Störungen der Feldhomogenität. Daher sind die erfinderischen Maßnahmen zur aktiven Reduzierung der temperaturinduzierten Shimdrift bei NMR-Magnetsystemen dieses Typs besonders vorteilhaft.

Nichtsdestotrotz sind die erfinderischen Maßnahmen auch bei NMR-Magnetsystemen von Nutzen, welche über keinen Heliumbehälter verfügen und bei welchen der supraleitende Magnet mittels eines Kryokühlers auf seine Betriebstemperatur gekühlt wird.

In den Rahmen der vorliegenden Erfindung fällt auch ein Verfahren zum Betrieb einer erfindungsgemäß mit einem Sensorelement modifizierten NMR-Apparatur, welches sich dadurch auszeichnet, dass auf einem Abschnitt eines Pfades entlang des Vakuumbehälters von der ersten mechanischen Verbindungsstelle zur zweiten mechanischen Verbindungsstelle und/oder auf einem Abschnitt eines Pfades entlang des Positionierungselementes von der zweiten mechanischen Verbindungsstelle zum Shimsystem mittels eines Sensorelementes die Temperatur und/oder die Dehnung des Vakuumbehälters und/oder des Positionierungselementes entlang des Pfadabschnittes gemessen und von einer elektronischen Regelungseinheit durch Ansteuerung eines Regulierungselementes zeitlich stabilisiert wird.

Dem zielführenden Betrieb einer solchen erfindungsgemäßen Anordnung liegt eine Regelungsaufgabe zu Grunde. Anhand der Messwerte eines Sensorelementes (Steuergröße) soll ein Setzwert (Stellgröße) für ein Regulierungselement bestimmt werden, so dass ein bestimmter Parameter (Regelgröße) einen festgelegten Wertebereich nicht verlässt. Die Temperatur und/oder die Dehnung des Vakuumbehälters und/oder des Positionierungselementes können in unterschiedlichen erfindungsgemäßen Ausführungsformen sowohl als Steuer- als auch als Regelgröße dienen. Die Stellgröße hängt vom Regulierungselement ab. Sie kann beispielsweise eine Stromstärke für ein Heizelement oder eine elektrische Spannung für ein Piezoelement sein. Ein Betriebsverfahren, welches zur Verarbeitung der Steuergröße und zur Bestimmung und Ausgabe der Stellgröße eine elektronische Regulierungseinheit, insbesondere einen PID-Regler, nutzt, ist vorteilhaft, weil sich solche Regler zur Lösung vergleichbarer Regelungsaufgaben besonders gut eignen.

Eine weitere vorteilhafte Verfahrensvariante sieht vor, dass eine Temperatur- oder Dehnungsänderung an einem Ort eines Pfadabschnitts mittels eines Sensorelementes detektiert wird und dass dieser Temperatur- oder Dehnungsänderung mit Hilfe der Regelungseinheit durch Ansteuerung eines an einem anderen Ort desselben oder eines anderen Pfadabschnitts positionierten Regulierungselementes entgegengewirkt wird.

Dieses Betriebsverfahren ermöglicht es beispielsweise, eine Temperaturmessung an einem Aufhängeturm als Steuergröße und die Dehnung eines mechanischen Aktuators am Positionierungselement als Regelgröße zu benutzen. Diese zusätzliche Flexibilität erlaubt es, für das Sensor- und für das Regulierungselement unabhängig voneinander eine jeder Aufgabe optimal angepasste Ausführungsform zu finden.

Besonders bevorzugt ist auch eine Verfahrensvariante, welche sich dadurch kennzeichnet, dass auf einem Abschnitt eines Pfades entlang des Vakuumbehälters von der ersten mechanischen Verbindungsstelle zur zweiten mechanischen Verbindungsstelle und/oder auf einem Abschnitt eines Pfades entlang des Positionierungselementes von der zweiten mechanischen Verbindungsstelle zum Shimsystem mittels eines Sensorelementes die Temperatur und/oder die Dehnung des Vakuumbehälters und/oder des Positionierungselementes entlang des Pfadabschnittes gemessen wird, und dass von einer elektronischen Regelungseinheit die Ströme durch die Shimelemente des Shimsystems derart angepasst werden, dass der Homogenitätsveränderung auf Grund der gemessenen Temperatur- und/oder Dehnungsänderungen entgegengewirkt wird, so dass die Feldhomogenität zeitlich stabilisiert wird.

In diesem Verfahren wird statt der Temperatur und/oder der Dehnung des Vakuumbehälters und/oder des Positionierungselementes die Feldhomogenität als Regelgröße behandelt, welche es zeitlich zu stabilisieren gilt. Dementsprechend werden durch die Regulierungseinheit nicht oder nicht nur die bis anhin beschriebenen Regulierungselemente angesteuert (welche ja nur einen indirekten Einfluss auf die zeitliche Stabilisierung der Feldhomogenität haben), sondern die Shimelemente (Spulen) eines elektrischen Shimsystems. Die Stellgrößen sind demnach die Ströme der einzelnen Shimelemente. Als Steuergröße sollen aber weiterhin die Messwerte eines erfindungsgemäßen Sensorelementes benutzt werden, weil Messungen der Feldhomogenität als Steuergröße nicht immer in ausreichend kurzer zeitlicher Abfolge zur Verfügung stehen. Die Nutzung des Shimsystems zur geregelten zeitlichen Stabilisierung der Feldhomogenität stellt eine apparative Vereinfachung gegenüber dem Einsatz von zusätzlichen Regulierungselementen dar, weil in einer NMR-Apparatur ohnehin meistens ein Shimsystem vorhanden ist. Außerdem reagiert ein Shimsystem ohne Verzögerung und hochpräzis. Die kleinen Shimstromanpassungen führen zudem kaum zu einer Veränderung der dissipierten Leistung im Shimsystem, so dass dessen Temperatur bei Anwendung dieses Verfahrens stabil bleibt und unerwünschte Rückkopplungseffekte ausbleiben.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine schematische vertikale Schnittansicht auf eine Ausführungsform der erfindungsgemäßen NMR-Apparatur, in welcher das Positionierungselement einen Klemmring umfasst, wobei die Auflagefläche des Klemmrings auf dem oberen Ende der Raumtemperatur-Bohrung des Vakuumbehälters die zweite mechanische Verbindungsstelle bildet;
- Fig. 2: einen schematischen Vertikalschnitt durch eine Ausführungsform der erfindungsgemäßen NMR-Apparatur ähnlich wie in Fig. 1, jedoch mit einem im Pfad entlang des Positionierungselementes von der zweiten mechanischen Verbindungsstelle zum Shimsystem angeordneten mechanischen Aktuator;
- Fig. 3: eine weitere Ausführungsform der erfindungsgemäßen NMR-Apparatur, in welcher das Positionierungselement ein Gerüst umfasst, wobei die Auflagefläche des Gerüsts auf dem oberen Ende des Aufhängeturms der Magnetaufhängung die zweite mechanische Verbindungsstelle bildet;
- Fig. 4: einen Ausschnitt der erfindungsgemäßen NMR-Apparatur mit dem Verschaltungsschema für mehrere Regulierungs- und Sensorelemente;

- Fig. 5: einen Ausschnitt der erfindungsgemäßen NMR-Apparatur mit dem Verschaltungsschema für mehrere Regulierungs- und Sensorelemente mit nur einem einzigen Regelkreis; und
- Fig. 6: eine schematische vertikale Schnittansicht auf eine Ausführungsform der erfindungsgemäßen NMR-Apparatur mit einem temperierten Fluid, welches die Aufhängetürme und das Positionierungselement auf einer konstanten Temperatur hält.

Generell befasst sich die vorliegende Erfindung mit einer modifizierten NMR-Apparatur mit einem Magnetspulensystem zur Erzeugung eines homogenen Magnetfelds, welches einen **supraleitenden Magneten 1** umfasst, der im Kaltbereich eines Kryostaten innerhalb eines **Vakuumbehälters 8** angeordnet ist. Außerdem umfasst die NMR-Apparatur ein **Shimsystem 7,** das außerhalb des Vakuumbehälters 8 angeordnete **Shimelemente 6** enthält, welche als elektrische Spulen und/oder als ferromagnetische Elemente ausgebildet sein können. Der supraleitende Magnet 1 weist zudem über eine **Magnetaufhängung 3** eine **erste mechanische Verbindungsstelle 11** mit dem Vakuumbehälter 8 auf, wobei die Magnetaufhängung 3 ihrerseits in einem **Aufhängeturm 4** angeordnet ist. Das Shimsystem 7 weist über ein **Positionierungselement 5** mit dem Vakuumbehälter 8 eine **zweite mechanische Verbindungsstelle 10; 12** auf.

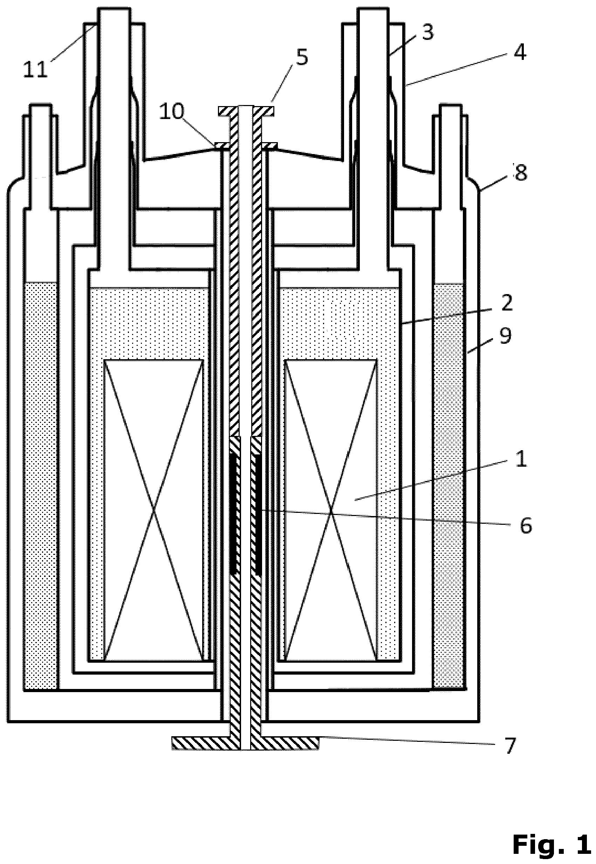

Das Shimsystem 7 umfasst neben den Shimelementen 6 typischerweise auch eine Halterungsstruktur der Shimelemente 6, so dass das Shimsystem 7 nicht nur funktional, sondern auch strukturell eine Einheit bildet. Die Halterungsstruktur erlaubt es, die Gesamtheit der Shimelemente 6 mit einem Positionierungselement 5 mechanisch zu verbinden, oder sie dient als Führung elektrischer Leitungen zu den Shimelementen 6 oder als mechanische Schnittstelle zu einem NMR-Probenkopf. Die begriffliche Unterscheidung zwischen Positionierungselement 5 und anderen strukturellen Komponenten, beispielsweise einer Halterungsstruktur der Shimelemente 6, sei dadurch gegeben, dass alle strukturellen Komponenten in einem Pfad zwischen einer zweiten mechanische Verbindungsstelle 10; 12 zum Vakuumbehälter 8 auf der einen Seite und mindestens einem Shimelement 6 auf der anderen Seite als Positionierungselemente 5 aufzufassen sind, wenn ihre Dehnung die Position oder Ausrichtung dieses Shimelementes 6 relativ zum supraleitenden Magneten 1 beeinflusst. In Fig. 1 ist eine besonders vorteilhafte zweiteilige mechanische Struktur zur Anordnung von Shimelementen 6 in einer Magnetbohrung gezeigt. Der obere Teil der mechanischen Struktur stellt den Verbindungspfad vom Shimsystem 7 zur zweiten mechanischen Verbindungsstelle 10 zwischen Klemmring und Vakuumbehälter 8 her und dient definitionsgemäß als Positionierungselement 5. Der untere Teil der mechanischen Struktur wird dem Shimsystem 7 zugerechnet und dient zur Halterung der Gesamtheit der Shimelemente 6, zur Einführung der Shimelemente 6 von unten in die Magnetbohrung, zur Aufnahme eines NMR-Probenkopfs und zur Führung elektrischer Zuleitungen zu den Shimelementen 6. Die zweiteilige Ausführung der mechanischen Struktur zur Anordnung der Shimelemente 6 vereinfacht den Einbau in die Magnetbohrung. Im Betriebszustand sind die beiden Strukturen beispielsweise durch Schrauben mechanisch verbunden. Demgegenüber sind auch einteilige Strukturen denkbar, bei welchen das Shimsystem 7 als Gesamtheit aller Shimelemente 6 keine strukturellen Komponenten aufweist und das Positionierungselement 5 auch als Halterung der Shimelemente 6 dient und weitere der oben genannten Funktionen übernehmen kann.

Der supraleitende Magnet 1 ist normalerweise in einem im Betrieb mit flüssigem Helium gefüllten **Heliumbehälter 2** des Kryostaten innerhalb des Vakuumbehälters 8 angeordnet, wobei der Heliumbehälter 2 vorzugsweise von einem mit flüssigem Stickstoff gefüllten **Stickstoffbehälter 9** des Kryostaten radial umgeben ist. Der Kryostat kann auch einen Kryokühler umfassen, mittels dessen der supraleitende Magnet 1 auf seine Betriebstemperatur gekühlt werden kann.

Vorzugsweise beträgt die Länge des zur Anbringung eines Regulierungselementes vorgesehenen Pfadabschnittes entlang des Vakuumbehälters 8 von der ersten mechanischen Verbindungsstelle 11 zur zweiten mechanischen Verbindungsstelle 10; 12 und/oder die Länge des zur Anbringung eines Regulierungselementes vorgesehenen Pfadabschnittes entlang des Positionierungselementes 5 von der zweiten mechanischen Verbindungsstelle 10; 12 zum Shimsystem 7 jeweils mehr als 50% der Gesamtlänge des entsprechenden Pfades.

In **Fig. 1** umfasst das Positionierungselement 5 einen Klemmring, dessen Auflagefläche auf dem oberen Ende der Raumtemperatur-Bohrung des Vakuumbehälters 8 die zweite mechanische Verbindungsstelle 10 bildet.

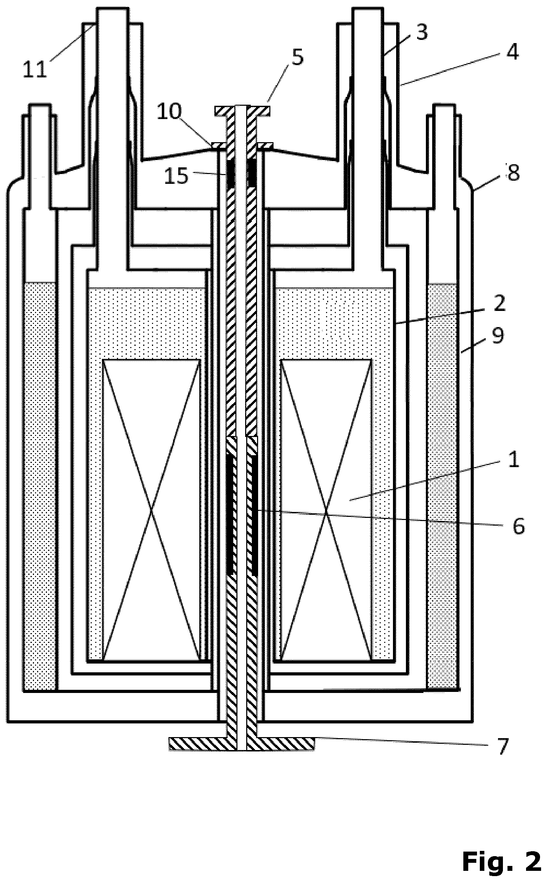

**Fig. 2** zeigt eine Ausführungsform der NMR-Apparatur wie in Fig. 1, jedoch zusätzlich mit einem **mechanischen Aktuator 15,** der unterhalb des Klemmrings 10 angeordnet ist.

Wie in Fig. 2 anschaulich dargestellt, kann der mechanische Aktuator 15 in das Positionierungselement 5 eingebaut sein und ist vorzugsweise als Piezoelement ausgeführt. Soll die Position des Shimsystems 7 verändert werden, kann das Piezoelement mit einer entsprechenden elektrischen Spannung gespeist werden. Die Längenänderung des Piezokristalls ist dann proportional zur angelegten Spannung und es sind auch negative Spannungen möglich. Mit der Dicke eines Piezostapels in Sandwichbauweise kann der Bereich der möglichen Verschiebung den Verschiebungsanforderungen angepasst werden.

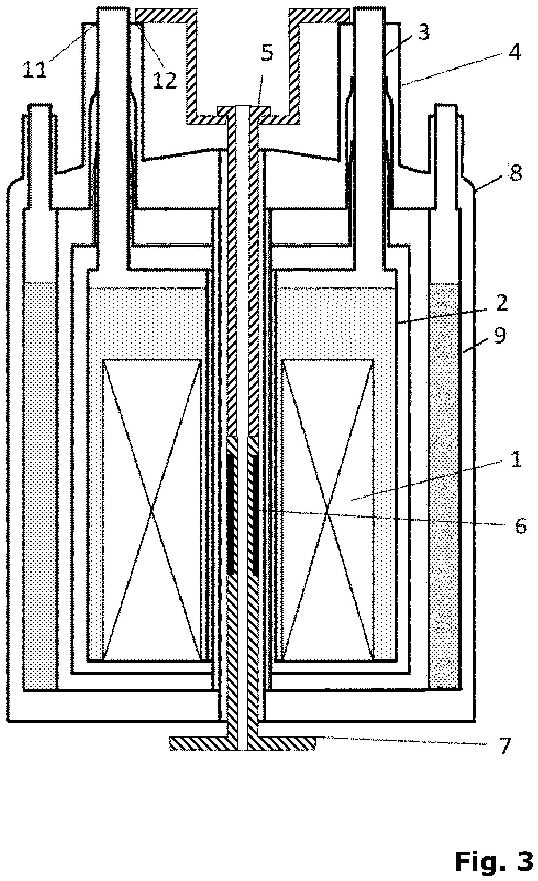

**Fig. 3** zeigt ein alternatives Positionierungselement 5 mit einem Gerüst, welches bis zum oberen Ende des Aufhängeturms 4 der Magnetaufhängung 3 reicht. Die Befestigungsstelle des Gerüsts am oberen Ende des Aufhängeturms 4 bildet die zweite mechanische Verbindungsstelle 12 zwischen Positionierungselement 5 und Vakuumbehälter 8. Auf diese Weise fallen die erste mechanische Verbindungsstelle 11 und die alternative zweite mechanische Verbindungsstelle 12 auf dem Vakuumbehälter 8 fast zusammen und der Pfad entlang des Vakuumbehälters 8, der die beiden mechanischen Verbindungsstellen 11; 12 miteinander verbindet, wird minimiert. Insbesondere kann das Gerüst aus einem Material mit kleinem Wärmeausdehnungskoeffizienten hergestellt werden, so dass sich keine wesentlichen Dehnungen bei Temperaturschwankungen ergeben.

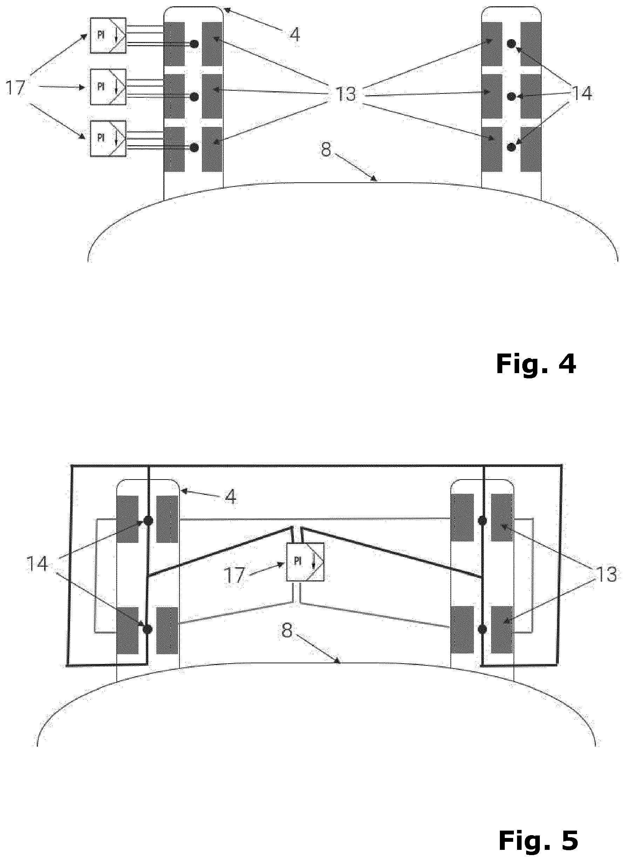

**Fig. 4** stellt einen Ausschnitt der erfindungsgemäßen NMR-Apparatur mit dem Verschaltungsschema für mehrere **Regulierungselemente 13** und **Sensorelemente 14** dar, welche auf den Aufhängetürmen 4 angeordnet sind. Mit Hilfe der Sensorelemente 14 wird die Dehnung oder die Temperatur der Aufhängetürme 4 gemessen und mit den Regulierungselementen 13 kann der gemessenen Dehnungsänderung entgegengewirkt werden. Mehrere **elektronische Regelungseinheiten 17** (hier in Form von PI-Reglern) verarbeiten die Signale (Steuergröße) der Sensorelemente 14 und bestimmen die Ausgabewerte (Stellgröße) für die Regulierungselemente 13. Die Regulierungselemente 13 sind hier als Heizelemente ausgeführt. Als Sensorelemente 14 können beispielsweise PT-100-Temperatursensoren verwendet werden. Diese Ausführungsform veranschaulicht, wie mit mehreren Regelkreisen die Dehnungsänderungen (Regelgröße) abschnittsweise auf den verschiedenen Aufhängetürmen 4 klein gehalten werden können. Mit einer solchen Lösung wird die maximale Kontrolle über die Dehnung gewonnen. Der Aufwand dafür ist freilich relativ groß, weil man mehrere Sensorelemente 14, Regulierungselemente 13 und elektronische Regelungseinheiten 17 braucht.

In der Regelungstechnik gibt es noch viele andere Regler, auf die hier aber nicht im Detail eingegangen werden soll.

Für eine Temperaturmessung sind PT-100 Sensoren eine gute Wahl, da sie im Raumtemperaturbereich besonders empfindlich sind. Alternativ dazu können andere Temperatursensoren oder Dehnungsmesselemente verwendet werden. Heizelemente umfassen meistens eine mäanderförmige Leiterbahn, die möglichst viel Fläche abdeckt.

Des Weiteren ist in Fig. 4 eine Stromspeisung der Regulierungselemente 13 und der Sensorelemente 14 schematisch angedeutet.

Die Aufhängetürme 4 samt Sensorelementen 14 und Regulierungselementen 13 werden üblicherweise mit Isolationsmaterial abgedeckt (was in der Figur allerdings nicht eigens dargestellt ist), um Schwankungen der Umgebungstemperatur zu dämpfen. Die Temperatur der Aufhängetürme 4 wird in diesem Beispiel durch die Heizer künstlich etwas höher gehalten als die Umgebungstemperatur, damit auf Erhöhungen der Umgebungstemperatur reagiert werden kann. Statt der Heizelemente können auch Kühlelemente, insbesondere thermoelektrische Kühler (TEC), verwendet werden. In diesem Fall wird die Temperatur der Aufhängetürme 4 sinnvollerweise tiefer gehalten als die Umgebungstemperatur.

Während in Fig. 4 ein Beispiel mit einer Vielzahl von PI-Reglern gezeigt wird, ist es auch möglich, deren Anzahl zu reduzieren, indem mehrere Regulierungselemente 13 und mehrere Sensorelemente 14 jeweils in Serie oder parallelgeschaltet werden, wobei die Steuer- und Stellgrößen durch den Regler gemittelt werden. Das reduziert oft ohne große Nachteile die Komplexität und den Preis der benötigten Elektronik.

Ein solches Ausführungsbeispiel ist in **Fig. 5** dargestellt. Die Kontrolle über die Dehnung der Aufhängetürme 4 ist allerdings etwas weniger präzise als beim Ausführungsbeispiel nach Fig. 4. Wenn jedoch für die Aufhängetürme 4 ein Material mit guter Wärmeleitfähigkeit verwendet wird, kann der Temperaturgradient über die Aufhängetürme 4 reduziert werden. Kombiniert mit einer guten Isolation der Aufhängetürme 4 gegenüber der Umgebungstemperatur kann die Dehnungsregelung weiter verbessert werden.

Je nach Anwendungsfall gibt es eine Fülle von Möglichkeiten, die sich zwischen den beiden hier vorgestellten Lösungen bewegen können.

Ähnliche Anordnungen wie für die Aufhängetürme 4 sind auch für das Positionierungselement 5 möglich.

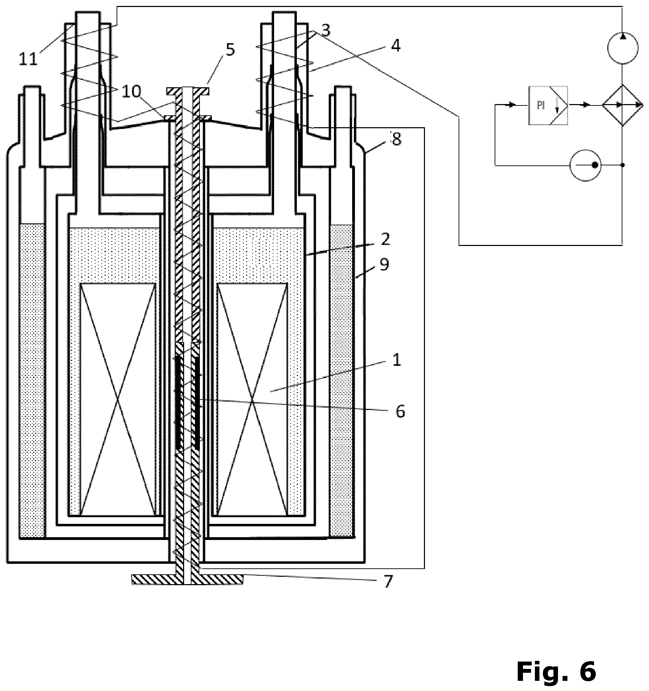

In der **Fig. 6** wird eine Ausführungsform mit einem Flüssigkeitskreislauf gezeigt, welcher entlang der Aufhängetürme 4 und des Positionierungselementes 5 geführt wird. Vorteilhaft an dieser Ausführungsform ist, dass zur Temperaturstabilisierung mehrerer Komponenten nur ein einziges geregeltes Heiz- oder Kühlelement notwendig ist. Eine Temperierflüssigkeit kann große Wärmemengen transportieren, so dass die Temperaturgradienten innerhalb der temperierten Objekte klein gehalten werden können. Dies verbessert die Präzision der Kontrolle thermischer Ausdehnung. Mit einer Isolation zum Außenraum kann der Temperaturgradient innerhalb der temperierten Objekte weiter reduziert werden. Als Temperierfluid kann auch ein Gas verwendet werden. Der Vorteil eines Gases liegt darin, dass es innerhalb der Magnetbohrung offen entlang des Positionierungselementes 5 geführt werden kann.

### Bezugszeichenliste:

- 1: Supraleitender Magnet
- 2: Heliumbehälter
- 3: Magnetaufhängung
- 4: Aufhängeturm
- 5: Positionierungselement des Shimsystems
- 6: Shimelemente
- 7: Shimsystem
- 8: Vakuumbehälter
- 9: Stickstoffbehälter
- 10: Zweite mechanische Verbindungsstelle
- 11: Erste mechanische Verbindungsstelle
- 12: Alternative zweite mechanische Verbindungsstelle
- 13: Regulierungselement
- 14: Sensorelement
- 15: Mechanischer Aktuator
- 17: elektronische Regelungseinheit

### Referenzliste

Für die Beurteilung der Patentfähigkeit in Betracht gezogene Publikationen:
[1] DE 101 04 365 C1 ≈ GB 2 411 238 B ≈ US 2005/0174118 A1
[2] EP 0 780 698 B1 ≈ US 5,744,959 A
[3] EP 2 015 092 A1
[4] EP 3 686 620 A1
[5] "Acyclic Acids-Advances in Research and Application: 2013 Edition: ScholarlyBrief", Q. Ashton Acton, PhD, ScholarlyEditions, 2013, p139
[6] "Modern Instrumental Analysis", Satinder Ahuja, Neil Jespersen, Elsevier, 2006, p270
[7] DE 10 2015 225 731 B3 ≈ EP 3 182 147 B ≈ US 9,766,312 B1 ≈
   ≈ CN 106898452 B ≈ JP 6340403 B

## Patentansprüche

1. NMR-Apparatur mit einem Magnetspulensystem zur Erzeugung eines homogenen Magnetfelds, welches einen supraleitenden Magneten (1) umfasst, der im Kaltbereich eines Kryostaten innerhalb eines Vakuumbehälters (8) angeordnet ist, und welches ein Shimsystem (7) umfasst, das außerhalb des Vakuumbehälters (8) angeordnete Shimelemente (6) enthält,
wobei der supraleitende Magnet (1) über eine Magnetaufhängung (3) eine erste mechanische Verbindungsstelle (11) mit dem Vakuumbehälter (8) aufweist, und wobei das Shimsystem (7) über ein Positionierungselement (5) mit dem Vakuumbehälter (8) eine zweite mechanische Verbindungsstelle (10; 12) aufweist,
**dadurch gekennzeichnet,**
**dass** auf einem Abschnitt eines Pfades entlang des Vakuumbehälters (8) von der ersten mechanischen Verbindungsstelle (11) zur zweiten mechanischen Verbindungsstelle (10; 12) und/oder auf einem Abschnitt eines Pfades entlang des Positionierungselementes (5) von der zweiten mechanischen Verbindungsstelle (10; 12) zum Shimsystem (7) ein Regulierungselement (13) zur Einstellung der Dehnung des Vakuumbehälters (8) und/oder des Positionierungselementes (5) entlang des Pfadabschnittes angeordnet ist.

2. NMR-Apparatur nach Anspruch 1, **dadurch gekennzeichnet, dass** das Regulierungselement (13) ein Temperierelement und/oder einen Wärmetauscher zur Übertragung von Wärme an ein oder aus einem temperierten Fluid umfasst.

3. NMR-Apparatur nach Anspruch 2, **dadurch gekennzeichnet,**
**dass** das Temperierelement als ein Heizelement, vorzugsweise als ein elektrischer Widerstandsheizer, ausgeführt ist,
und/oder dass das Temperierelement als Kühlelement, insbesondere als ein thermoelektrischer Kühler ausgeführt ist.

4. NMR-Apparatur nach einem der vorhergehenden Ansprüche, **dadurch gekennzeichnet, dass** das Regulierungselement (13) mindestens einen, vorzugsweise mechanischen, Aktuator (15) umfasst, insbesondere einen Motor und/oder ein Piezoelement, mittels dessen die Dehnung des Vakuumbehälters (8) und/oder des Positionierungselementes (5) entlang des Pfadabschnittes und/der die Lage des Positionierungselementes (5) gegenüber dem Vakuumbehälter (8) eingestellt werden kann.

5. NMR-Apparatur nach einem der vorhergehenden Ansprüche, **dadurch gekennzeichnet, dass** auf einem Abschnitt eines Pfades entlang des Vakuumbehälters (8) von der ersten mechanischen Verbindungsstelle (11) zur zweiten mechanischen Verbindungsstelle (10; 12) und/oder auf einem Abschnitt eines Pfades entlang des Positionierungselementes (5) von der zweiten mechanischen Verbindungsstelle (10; 12) zum Shimsystem (7) ein Sensorelement (14) zur Messung der Dehnung und/oder der Temperatur des Vakuumbehälters (8) und/oder des Positionierungselementes (5) entlang des Pfadabschnittes angeordnet ist, welches vorzugsweise ein Thermometer, insbesondere einen PT-100 Sensor, und/oder ein Dehnungsmesselement umfasst.

6. NMR-Apparatur nach Anspruch 5, **dadurch gekennzeichnet, dass** das Sensorelement (14) ein Dehnungsmesselement umfasst, insbesondere einen Widerstandssensor, vorzugsweise einen Dehnungsmessstreifen, oder einen optischen Dehnungssensor, vorzugsweise einen Faser-Bragg-Gitter-Sensor, oder einen Laser, mit welchem mittels einer elektrooptischen Distanzmessung, insbesondere interferometrisch, eine Dehnungsänderung eines beobachteten Pfadabschnitts detektiert werden kann.

7. NMR-Apparatur nach einem der Ansprüche 5 oder 6, **dadurch gekennzeichnet, dass** das Regulierungselement (13) an einem Ort auf einem Abschnitt eines Pfades entlang des Vakuumbehälters (8) von der ersten mechanischen Verbindungsstelle (11) zur zweiten mechanischen Verbindungsstelle (10; 12) und/oder auf einem Ort auf einem Abschnitt eines Pfades entlang des Positionierungselementes (5) von der zweiten mechanischen Verbindungsstelle (10; 12) zum Shimsystem (7) angeordnet ist, und dass das Sensorelement (14) an einem anderen Ort desselben oder eines anderen Pfadabschnitts angeordnet ist.

8. NMR-Apparatur nach einem der vorhergehenden Ansprüche, **dadurch gekennzeichnet, dass** auf einem Abschnitt eines Pfades entlang des Vakuumbehälters (8) von der ersten mechanischen Verbindungsstelle (11) zur zweiten mechanischen Verbindungsstelle (10; 12) und/oder auf einem Abschnitt eines Pfades entlang des Positionierungselementes (5) von der zweiten mechanischen Verbindungsstelle (10; 12) zum Shimsystem (7) eine thermische Isolation angebracht ist.

9. NMR-Apparatur nach einem der vorhergehenden Ansprüche, **dadurch gekennzeichnet, dass** der Vakuumbehälter (8) eine vertikale Raumtemperatur-Bohrung aufweist, in welcher das Shimsystem (7) angeordnet ist, und dass das Positionierungselement (5) einen Klemmring umfasst, wobei die Auflagefläche des Klemmrings auf dem oberen Ende der Raumtemperatur-Bohrung des Vakuumbehälters (8) die zweite mechanische Verbindungsstelle (10) bildet.

10. NMR-Apparatur nach einem der vorhergehenden Ansprüche, **dadurch gekennzeichnet, dass** auf einem Pfad entlang des Vakuumbehälters (8) von der ersten mechanischen Verbindungsstelle (11) zur zweiten mechanischen Verbindungsstelle (10; 12) und/oder auf einem Pfad entlang des Positionierungselementes (5) von der zweiten mechanischen Verbindungsstelle (10; 12) zum Shimsystem (7) abschnittsweise Materialien mit unterschiedlichen Wärmeausdehnungskoeffizienten eingesetzt sind, deren Wärmeausdehnungen sich jeweils gegenseitig kompensieren.

11. NMR-Apparatur nach einem der vorhergehenden Ansprüche, **dadurch gekennzeichnet, dass** auf mindestens einem Abschnitt eines Pfades entlang des Vakuumbehälters (8) von der ersten mechanischen Verbindungsstelle (11) zur zweiten mechanischen Verbindungsstelle (10; 12) und/oder auf mindestens einem Abschnitt eines Pfades entlang des Positionierungselementes (5) von der zweiten mechanischen Verbindungsstelle (10; 12) zum Shimsystem (7) nur Materialien eingesetzt sind, deren Wärmeausdehnungskoeffizient bei Betriebstemperatur kleiner ist als 5 ppm/K.

12. NMR-Apparatur nach einem der vorhergehenden Ansprüche, **dadurch gekennzeichnet, dass** der supraleitende Magnet (1) in einem im Betrieb mit flüssigem Helium gefüllten Heliumbehälter (2) des Kryostaten innerhalb des Vakuumbehälters (8) angeordnet ist, wobei der Heliumbehälter (2) vorzugsweise von einem mit flüssigem Stickstoff gefüllten Stickstoffbehälter (9) des Kryostaten radial umgeben ist.

13. Verfahren zum Betrieb einer NMR-Apparatur nach einem der Ansprüche 5 bis 12, **dadurch gekennzeichnet, dass** auf einem Abschnitt eines Pfades entlang des Vakuumbehälters (8) von der ersten mechanischen Verbindungsstelle (11) zur zweiten mechanischen Verbindungsstelle (10; 12) und/oder auf einem Abschnitt eines Pfades entlang des Positionierungselementes (5) von der zweiten mechanischen Verbindungsstelle (10; 12) zum Shimsystem (7) mittels eines Sensorelementes (14) die Temperatur und/oder die Dehnung des Vakuumbehälters (8) und/oder des Positionierungselementes (5) entlang des Pfadabschnittes gemessen und von einer elektronischen Regelungseinheit (17) durch Ansteuerung eines Regulierungselementes (13) zeitlich stabilisiert wird.

14. Verfahren zum Betrieb einer NMR-Apparatur nach Anspruch 7, **dadurch gekennzeichnet, dass** eine Temperatur- oder Dehnungsänderung an einem Ort eines Pfadabschnitts mittels eines Sensorelementes (14) detektiert wird und dass dieser Temperatur- oder Dehnungsänderung mit Hilfe der Regelungseinheit (17) durch Ansteuerung eines an einem anderen Ort desselben oder eines anderen Pfadabschnitts positionierten Regulierungselementes (13) entgegengewirkt wird.

15. Verfahren zum Betrieb einer NMR-Apparatur nach einem der Ansprüche 5 bis 12, **dadurch gekennzeichnet, dass** auf einem Abschnitt eines Pfades entlang des Vakuumbehälters (8) von der ersten mechanischen Verbindungsstelle (11) zur zweiten mechanischen Verbindungsstelle (10; 12) und/oder auf einem Abschnitt eines Pfades entlang des Positionierungselementes (5) von der zweiten mechanischen Verbindungsstelle (10; 12) zum Shimsystem (7) mittels eines Sensorelementes (14) die Temperatur und/oder die Dehnung des Vakuumbehälters (8) und/oder des Positionierungselementes (5) entlang des Pfadabschnittes gemessen wird, und dass von einer elektronischen Regelungseinheit (17) die Ströme durch die Shimelemente (6) des Shimsystems (7) derart angepasst werden, dass der Homogenitätsveränderung auf Grund der gemessenen Temperatur- und/oder Dehnungsänderungen entgegengewirkt wird, so dass die Feldhomogenität zeitlich stabilisiert wird.
